# EUROPEAN PATENT APPLICATION

(11) **EP 1 341 219 A2**
(43) Date of publication of application: **03.09.2003**
(21) Application number: 03004466.3
(22) Date of filing: 27.02.2003
(51) Int. Cl.: H01L 21/02

(54) **Method of fabricating semiconductor device**

(30) Priority: 28.02.2002 JP 2002053066
(71) Applicant: NEC Electronics Corporation, Kawasaki, Kanagawa 211-8668 (JP)
(72) Inventor: Takemura, Koichi, c/o NEC Electronics Corporation, Kawasaki, Kanagawa 211-8668 (JP)
(74) Representative: Glawe, Delfs, Moll & Partner

(57) **Abstract**

On an insulating film on a surface of a substrate a lower electrode (141) of a memory capacitor (140) is formed, and on the lower electrode a ferroelectric film (142) is formed at a temperature equal to or less than 450 degree centigrade, or at a temperature equal to or less than the Curie temperature of the ferroelectric film. Thereafter, on the ferroelectric film an upper electrode (143) is formed, and after the upper electrode is formed, heat treatment is applied at a temperature higher than the deposition temperature or the Curie temperature. Thereby, a ferroelectric film having a particular crystal orientation is formed, and when heat treatment at a temperature higher than the deposition temperature or the Curie temperature is applied to transform once to a paraelectric phase, without altering a crystal structure, a ferroelectric phase can be obtained, and thereby a ferroelectric film aligned in the spontaneous polarization orientations of the respective domains can be obtained.

## Description

### BACKGROUND OF THE INVENTION

### Technical Field of the Invention

The present invention relates to a method of fabricating a semiconductor device, in particular to a method of fabricating a semiconductor device such as a semiconductor memory device provided with a capacitor having a ferroelectric film.

### Description of the Related Art

In recent semiconductor devices, in particular in semiconductor memory devices provided with transistors and capacitors, one that uses ferroelectric films for capacitor dielectrics has been proposed. So far, in a method of fabricating a capacitor provided with this kind of the ferroelectric films, after a lower electrode is formed on an insulating film on a surface of a semiconductor substrate, thereon a ferroelectric film is formed, further thereon an upper electrode is formed, and thereafter these upper electrode, ferroelectric film and lower electrode are formed into a predetermined pattern. Furthermore, in the fabricating method thereof, as a method of fabricating the ferroelectric film, largely divided, two methods have been taken. The first one a method in which a ferroelectric film that is crystallized is directly formed at relatively higher temperatures, and the second one is a method in which a paraelectric film (a dielectric film that has a non-crystalline structure or a crystal structure that does not exhibits the ferroelectric properties) is formed at relatively low temperatures followed by heat treatment, and thereby the paraelectric film is transformed into a ferroelectric film.

For instance, according to technology disclosed in JP-A-10-173140 (first existing technology), on an Ir (iridium) lower electrode, a PbTiO₃ layer is formed, and thereon by use of a reactive sputtering method a PZT (lead zirconate titanate: Pb(Zr₁₋ₓTiₓ)O₃) film is formed. At this time, when the PZT film is formed at higher temperatures in the range of 600 to 700 degrees centigrade and the lower layer PbTiO₃ works as a crystal nucleus, the PZT film is formed as a ferroelectric film. Thereon, an Ir upper electrode is formed. In the technology set forth in the publication, after the formation of the PZT film, heat treatment at high temperatures in oxygen is applied. The publication, however, describes that this process is intended to compensate oxygen deficiency at the sputtering. Accordingly, it is considered that the first existing technology is one that corresponds to the first method of directly forming a ferroelectric film.

Furthermore, in technology set forth in JP-A-2000-223662 (second existing technology), on a laminated lower electrode, Pt (platinum)/Ti (titanium) /IrO₂ (iridium oxide), a PZT layer is formed, further an upper electrode made of Au (gold) or the like is formed, thereafter in an oxygen atmosphere heat treatment is applied at 700 degree centigrade for 1 min and thereby a crystallization anneal of the PZT film is applied, and by the crystallization anneal a ferroelectric film made of the PZT film is formed. In the publication, there is no clear mention of a crystal structure of the PZT layer, however, judging from description that after the formation of the PZT film the crystallization anneal is applied, an originally formed PZT film is considered to be an amorphous layer or a layer of a crystal structure that ,does not exhibit the ferroelectric properties. Accordingly, the second existing technology is considered to be one that corresponds to the second method in which a paraelectric film is formed followed by transforming into a ferroelectric film.

Thus, in the first existing technology, by promoting atoms and ions of the PZT film to diffuse, a desired crystal structure is formed when the PZT film is formed, and thereby a ferroelectric film is formed. At this time, in order to obtain a high quality crystal, it is necessary to promote the diffusion due to thermal energy, and for this the film has to be deposited at temperatures such high as 600 degree centigrade or more. However, since the heat treatment at such high temperatures becomes a factor of thermal degradation of elements or wirings formed in the preceding processes, it is difficult to apply a deposition technology at such high temperatures to an actual process of fabricating a semi conductor device. Furthermore, as a deposition temperature becomes higher, grain sizes of the crystal constituting the ferroelectric film become larger, accordingly the irregularity of the film becomes larger, resulting in causing an increase in a leakage current and a decrease in the breakdown voltage. Still furthermore, though it is not impossible to fabricate a ferroelectric film at temperatures as low as possible, atoms and ions diffuse insufficiently and poor crystallinity results, that is, it is difficult to obtain a high quality ferroelectric jfilm. Furthermore, unless the heat treatment is applied after the upper electrode is formed, owing to space charges and crystal defects formed in a boundary surface with the ferroelectric film at forming the upper electrode, inactive domains (a region where spontaneous polarization directions are aligned in the same direction) are contained, domains respond non-uniformly to an external electric field, and thereby lowering of the residual polarization or an increase in switching time may be caused. In addition, unless the heat treatment after the formation of the upper electrode is not implemented, structural defects formed on a surface during the growth of the ferroelectric film or structural defects introduced on a surface of the ferroelectric film during the formation of the upper electrode are not recovered or diminished, resulting in causing lowering of the breakdown voltage.

On the other hand, in the second existing technology, after an amorphous film or a paraelectric film is formed, heat treatment is necessary to transform the crystallinity. Since at that time a higher temperature of 600 degree centigrade or more is required, similarly to the case of the first existing technology, the heat treatment becomes a factor that causes the thermal degradation of the element or wiring, resulting in difficulty in applying in an actual process of fabricating a semiconductor device. Furthermore, although the heat treatment can be applied at lower temperatures, only a film abundant in defect and low in the ferroelectric properties can be obtained. Still furthermore, since nucleus generation and nucleus growth when transition to a ferroelectric phase is caused can be controlled with difficulty, the crystal orientation is inferior and the spontaneous polarization directions of domains are impossible to align, resulting in difficulty in obtaining a film excellent in the polarization properties. Furthermore, it is identical to the first existing technology in that after the formation of the upper electrode the heat treatment has to be applied, accordingly inactive domains may be contained and the domain response to the external electric field becomes irregular, and thereby a remanent polarization value may be lowered or the breakdown voltage may be deteriorated.

Accordingly, in the existing technologies of fabricating ferroelectric films or capacitors, since an amount of switchable polarization of the ferroelectric film is small, when a capacitor due to such fabricating technology is applied to a semiconductor device that is driven at low voltages that are demanded in recent semiconductor devices, at the low voltages the polarization switching of the ferroelectric film becomes difficult, resulting in causing a problem in that necessary characteristics, that is, necessary signal voltage cannot be obtained.

### SUMMARY OF THE INVENTION

An object of the present invention is to provide a rnethod of fabricating a semiconductor device provided with a capacitor that is large in an amount of polarization inversion electric charges, capable of switching polarization at lower voltages and constituted of a ferroelectric film high in the breakdown voltage.

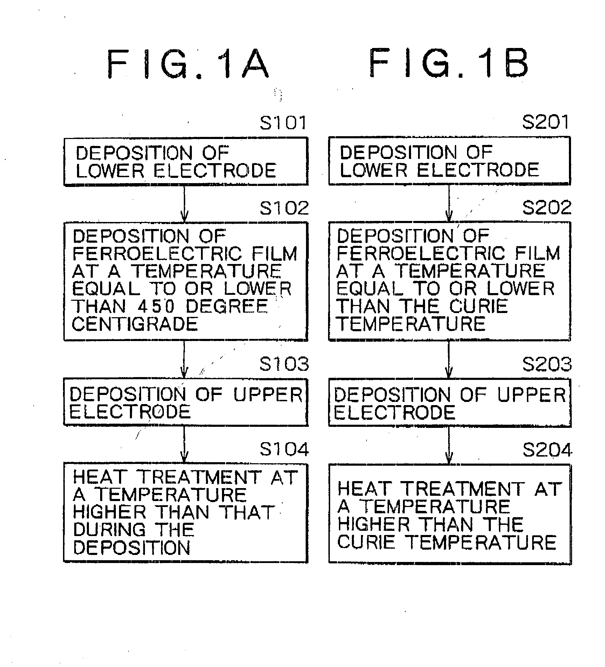

A first method of fabricating a semiconductor device according to the invention, with reference to a flowchart shown in Fig. 1A, comprises forming a lower electrode on an insulating film on a surface of a substrate such as a semiconductor substrate: (step S101); forming a ferroelectric film on the lower electrode at a temperature of 450 degree centigrade or lower (step S102); forming an upper electrode on the ferroelectric film (step S103); and applying heat treatment, after the formation of the upper electrode, at a temperature higher than a deposition temperature of the ferroelectric film (step S104); and thereby comprises forming a capacitor that is made of the lower electrode, the ferroelectric film and the upper electrode.

Furthermore, a second method of fabricating a semiconductor device according to the invention, with reference to a flowchart shown in Fig. 1B, comprises forming a lower electrode on an insulating film on a surface of a substrate such as a semiconductor substrate (step S201); forming a ferroelectric film on the lower electrode at a temperature equal to or lower than the Curie temperature of the ferroelectric film (step S202); forming an upper electrode on the ferroelectric film (step S203); and applying heat treatment, after the formation of the upper electrode, at. a temperature higher than the Curie temperature (step S204).

In the first and second methods of fabricating a semiconductor device according to the invention, after the formation of the upper electrode, the upper electrode or the ferroelectric film and the lower electrode may be formed into a necessary pattern followed by the heat treatment. Alternatively, after the upper electrode is formed into a necessary pattern and furthermore a cover film that covers at least the upper electrode is formed, the heat treatment may be applied.

In the first and second fabricating methods according to the invention, in the process of forming the ferroelectric film (step S102 and S202), it is preferably formed by use of an MOCVD method with an organometallic gas (metalorganic chemical vapor deposition method). In this case, when the MOCVD method is applied under lower pressure conditions, at lower temperatures, a ferroelectric film higher in the crystal orientation can be formed. In particular, in the first fabricating method, as described in the publication of JP-A-2000-58526, when a pressure during the MOCVD is set higher than 1330 mPa, molecules of the organometallic gas and molecules of oxygen repeat many times of collisions before reaching a substrate surface, and thereby micro-crystallites whose composition are not controlled result. When the pressure is set equal to or lower than the above pressure value, the micro-crystallites that become a factor of destroying the crystal structure can be substantially inhibited from being generated. As a result, even at lower temperatures, a ferroelectric film higher in the crystal orientation can be formed.

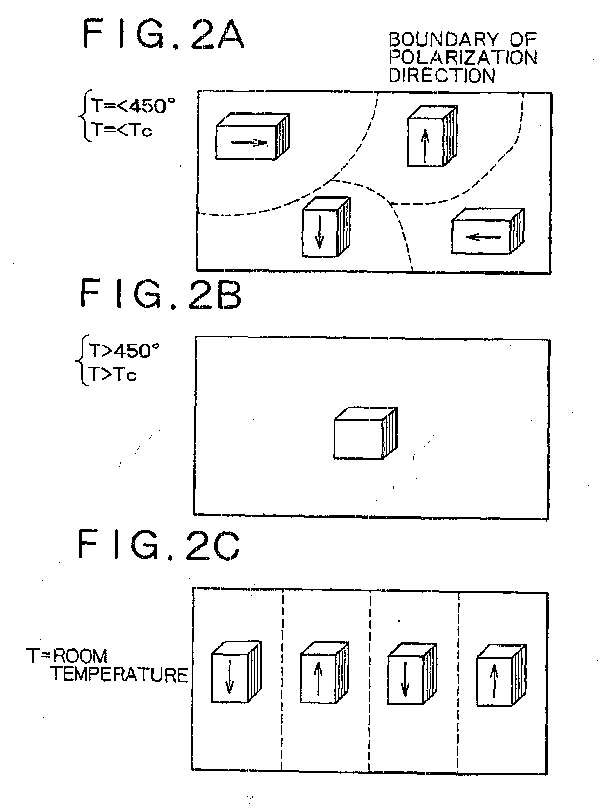

According to the first and second fabricating methods of a semiconductor device according to the invention, as schematically shown in Figs. 2A through 2C, when the ferroelectric film is formed at 450 degree centigrade or less or at the Curie temperature Tc or less, the ferroelectric film grows so as to be constituted of particular crystal surfaces that are small in the surface energy, and a ferroelectric film having a particular crystal orientation results. As shown in Fig. 2A, ferroelectric domains of such ferroelectric film are restricted in spontaneous polarization direction because of the crystal orientation, however, even under the restriction, various directions can be taken. When the ferroelectric film in such state is elevated to a temperature higher than 450 degree centigrade that is the upper limit of the deposition temperature, or to a temperature higher than the Curie temperature Tc, as shown in Fig. 2B, a phase transition to a paraelectric phase or to a state substantially close to that is caused. As a result, the spontaneous polarization disappears. However, since the phase transition does not involve diffusion of atoms and ions, except for spontaneous strain, the fundamental crystal structure remains the same. When during the cooling a temperature of a thin film becomes, in particular, the Curie temperature Tc or less, as shown in Fig. 2C, the paraelectric phase undergoes a transition to a ferroelectric phase. The structures and directions of the spontaneous polarizations of the respective ferroelectric domains generated at that time, irrespective of states before the heat treatment, are determined by thermal stress and an internal electric field generated by space charges during the cooling. Since the internal electric field and the thermal stress, after an MIM (metal-insulator-metal) structure is formed, are applied substantially uniformly in the ferroelectric thin film, reflecting the uniform strain and the internal electric field, the spontaneous polarization directions of the respective domains are aligned. When the spontaneous polarization directions of the domains in the ferroelectric thin film are aligned, asymmetry of switching response to the external electric field disappears, uniform polarization switching occurs. Furthermore, since an internal electric field that partially blocks the domains is reduced owing to the heat treatment, inactive domains decrease in comparison with that before the heat treatment. An improvement in the symmetry of the switching and a decrease in the inactive domains cause an increase in an amount of effective switchable charges. Furthermore, the decrease in the internal electric field causes a decrease in the coercive voltage. Still furthermore, when the heat treatment is applied in a state where electrodes are in contact, structural defects in an interface between the ferroelectrics and the electrode decrease, resulting in realizing an improvement in the breakdown voltage.

Furthermore, the first and second fabricating methods according to the invention, in the forming the ferroelectric film, may comprises forming initial nucleuses on a surface of the lower electrode and forming, on the initial nucleuses, a ferroelectric film under conditions different lfrom that of the initial nucleuses. In this case, it is preferable to include supplying Pb or Bi organometallic raw material gas singly or together with an oxidizing gas, and thereafter carrying out the formation of the initial nucleuses or the formation of the ferroelectric film. Still furthermore, it is preferable to form the initial nucleuses at a temperature in the range of 300 to 450 degree centigrade and to form the ferroelectric film at a temperature higher than the above. Thus, when the Pb or Bi organometallic raw material gas is supplied, the raw material gas is decomposed on the lower electrode, and thereby a precursor of a constituent element is absorbed. Accordingly, even when, during the formation of the ferroelectric film, a particular element (Pb or Bi) may form an alloy together with an electrode raw material to result in deficiency of the element at a lower electrode interface, the deficiency of the element can be inhibited and preferable initial nucleuses can be deposited. Furthermore, when the initial nucleuses are deposited at lower temperatures, a ferroelectric film that is small in the grain size, less in the irregularity and flat can be formed.

### BRIEF DESCRIPTION OF THE DRAWINGS

Figs. 1A and 1B are flowcharts showing steps of a method of fabricating a semiconductor device according to the invention.
Figs. 2A through 2C are diagrams schematically showing a crystal structure and a polarization direction of a ferroelectric film in the invention.
Fig. 3 is a circuit diagram of one example of a shadow RAM provided with a ferroelectric capacitor.
Fig. 4 is a sectional view showing a schematic configuration of the shadow RAM shown in Fig. 3.
Figs. 5A through 5D are sectional views of essential portions showing steps of fabricating a ferroelectric capacitor.
Fig. 6 is an X-ray diffraction pattern of a PZT film deposited according to a method of the invention.
Fig. 7 is a diagram showing correlation between deposition temperature and direction of crystal orientation.
Fig. 8 is a diagram showing correlation between deposition pressure and crystal orientation peak height.
Fig. 9 is a phase diagram of a PZT film.
Fig. 10 is a diagram showing correlation between heat treatment temperature and remanent polarization.
Figs. 11A and 11B are diagrams showing correlation between heat treatment temperature and leakage current.
Figs. 12A and 12B are flowcharts showing modified steps of a fabricating method according to the invention.
Figs. 13A and 13B are diagrams showing correlation between RTA and switching properties.
Figs. 14A and 14B are circuit diagrams of a FeRAM thereto the invention is applied.
Fig. 15 is a sectional view showing a structure of a 2T2C type FeRAM.

### PREFERRED EMBODIMENTS OF THE INVENTION

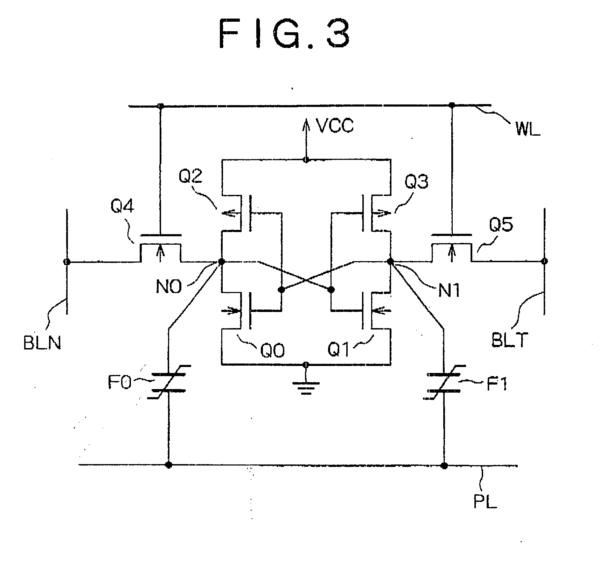

In the next place, an embodiment of the invention will be explained with reference to the drawings. The embodiment is an example in which the invention is applied to a so-called shadow RAM in which a ferroelectric capacitor is connected to an SRAM constituted of a MOS transistor. In the shadow RAM, as a circuit diagram thereof is shown in, for instance, Fig. 3, each of a pair of cascade connected N channel MOS transistors Q0, Q1 and a pair of cascade connected P channel MOS transistors Q2, Q3 is connected between a power supply VCC and a GND and both pairs are cross connected, to connection nodes N0, N1 thereof N channel MOS transistors Q4, Q5 are connected, respectively, and to these transistors a word line WL, bit lines BLN, BLT are connected. Furthermore, to the connection nodes N0, N1, ferroelectric capacitors F0, F1 are connected, and furthermore a plate line PL is connected thereto. Though detailed descriptions of the operation of the shadow RAM will be omitted, when potentials of the connection nodes N0, N1 are memorized in the ferroelectric capacitors F0 F1 the shadow RAM can function as a non-volatile memory element.

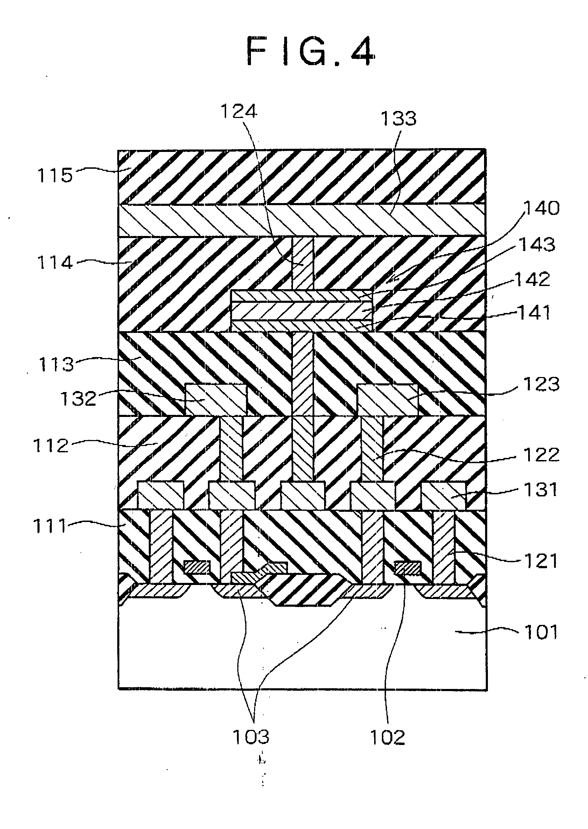

Fig. 4 is a schematic sectional view of the shadow RAM. On a surface of a silicon substrate 101, a gate electrode (word line) 102 is formed, and on a main surface of the silicon substrate 101, a source and drain region 103 is formed and each of the P channel and the N channel MOS transistors Q0 through Q5 is formed. A first interlayer insulating film 111 made of a silicon oxide film is formed so as to cover the MOS transistors and in the first interlayer insulating film 111 a contact hole for electrically connecting with the source and drain region 103 of the MOS transistor is opened, and in the contact hole a conductive material such as tungsten and so on is buried and thereby a contact plug 121 is formed. Then, on the first interlayer insulating film 111, a multi-layered wiring structure in which a first wiring layer 131, a second interlayer insulating film 112, a second wiring layer 132 and a third interlayer insulating film 113 are sequentially laminated is formed, and from the first wiring layer 131 the bit lines BL, BLT are formed and from the second wiring layer 132 the power supply VCC line and the GND line are formed. The first wiring layer 131 is electrically connected through the contact plug 121 to the MOS transistor, Furthermore, the second wiring layer 132 that is the power supply VCC line and the GND line is electrically connected through the contact plugs 122 and 121 that are formed in the second interlayer insulating film 112 and the first interlayer insulating film 111, respectively, to the MOS transistor. Still furthermore, on the third interlayer insulating film 113 that is the uppermost layer ferroelectric capacitors 140 (F0, F1.) having an MIM structure are formed and are connected through the contact plugs 123 and 122 formed respectively in the third interlayer insulating film 113 and the second interlayer insulating film 112 to the connection nodes N0 and N1 in the first wiring layer 131.

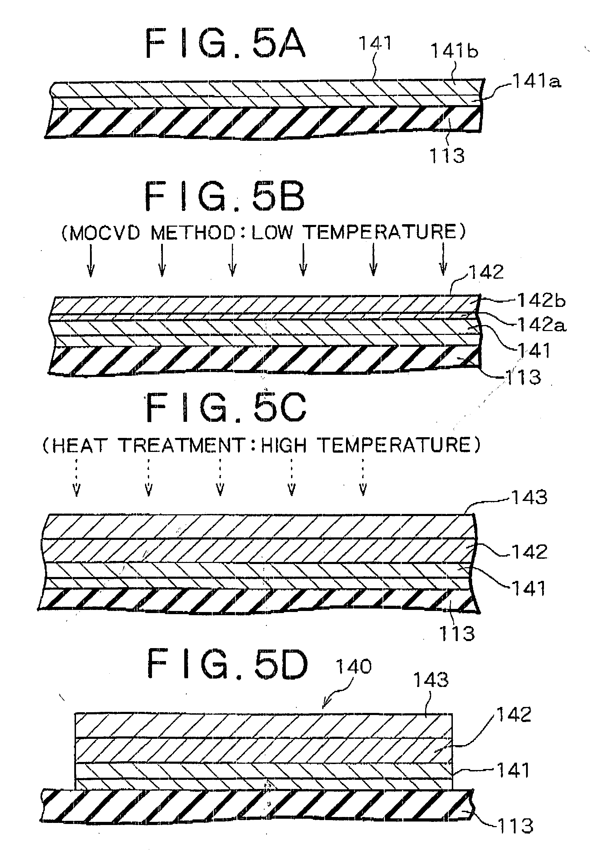

Figs. 5A through 5D are sectional views showing according to process order a method of forming a ferroelectric capacitor 140 having the HIM structure. First, as shown in Fig. 5A, on the third interlayer insulating film 113 made of a silicon oxide film or the like a lower electrode 141 is formed. When the lower electrode 141 is formed, according to the sputtering method, a TiN/Ti film 141a is formed as a contact layer on the third interlayer insulating film 113, subsequently by use of the sputtering method a Pt film 141b is deposited to a film thickness of 100 nm, and thereby the lower electrode 141 having a Pt/TiN/Ti laminate structure is formed. In place of the Pt film, a Ru film may be formed.

Subsequently, as shown in Fig. 5B, on the lower electrode 141 a PZT film 142 as a ferroelectric film is formed. When a first fabricating method of the invention is applied to the formation of the PZT film 142, the PZT film 142 is formed according to the MOCVD method (metalorganic chemical vapor deposition method) with Pb(DPM)₂, Zr (OtBu)₄. and Ti(OiPr)₄ as raw material gases and with NO₂ as an oxidizing gas. DPM denotes dipivaloylmethanate, OtBu denotes t-butoxide, and OiPr denotes i-propoxide. At the formation of the PZT film 142, a substrate thereon up to the lower electrode 141 is deposited is heated to 330 degree centigrade and Pb (DPM)₂, Ti(OiPr)₄ and NO₂ are simultaneously supplied at flow rates of 0.2 SCCM, 0.25 SCCM and 3.0 SCCM, respectively, for 30 seconds, and thereby on a surface of the lower electrode 141 initial nucleuses 142a, a very thin PbTiO₃ film, are formed. Thereafter, the substrate is heated up to 430 degree centigrade, furthermore in order that a composition of the PZT film obtained after the growth may be Pb(Zr_{0.33} Ti_{0.67})O₃, supply amounts of raw material gases are altered to such as 0.25 SCCM, 0.225 SCCM, 0.2t SCCM and 3.0 SCCM for Pb(DPM)₂, Zr(OtBu)₄, Ti(OiPr)₄ and NO₂, respectively, and thereby a PZT film 142b having a film thickness of 250 nm is formed. A pressure during the MOCVD growth is set at 665 mPa. Thereby, the initial nucleuses are integrated with the PZT film during the growth of the PZT film and finally the PZT film 142 that is made of the PZT phase alone and has a 001/100 orientation is obtained.

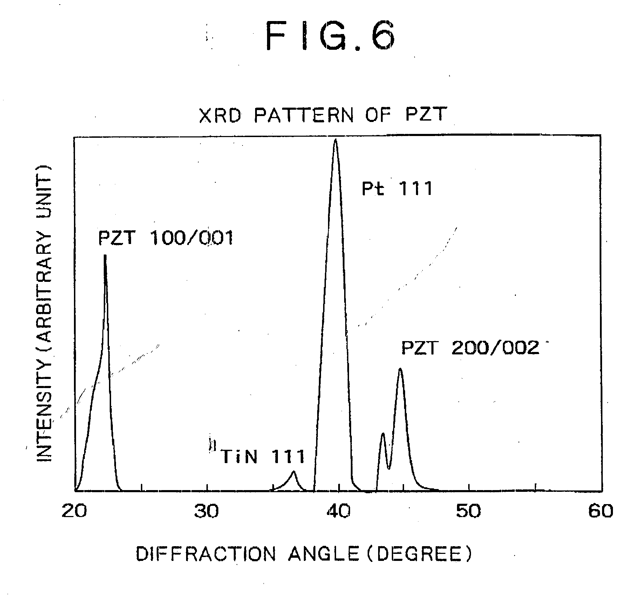

Fig. 6 is an XRD pattern obtained by X-ray diffraction of the PZT film 142. It is confirmed that in the pattern, together with peaks of the respective orientation planes of TiN and Pt that constitute the lower electrode 141, a peak of PZT001/100 orientation of the PZT film 142 is shown. In the same drawing, a peak of PZT002/200 orientation that is a multiple orientation of PZT001/100 is observed.

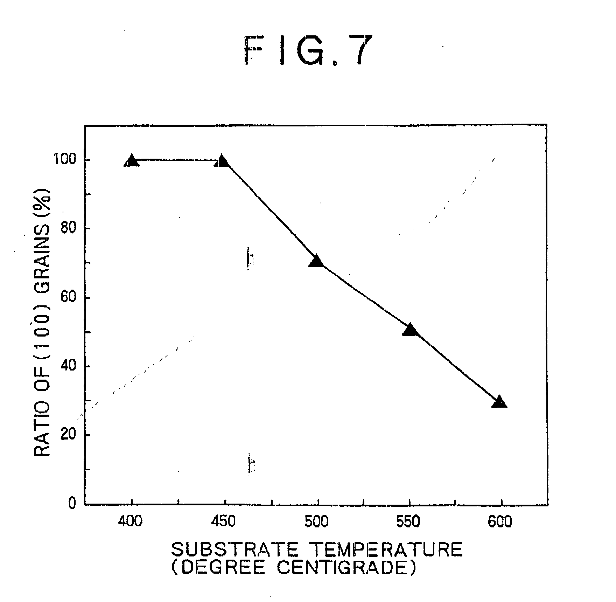

Fig. 7 is a diagram that is obtained from X-ray diffraction spectrum when the deposition temperature is varied and shows a change of a ratio of grains whose crystal axis in a direction perpendicular to the substrate is 100 in the grains of the PZT film 142. As mentioned above, it is found that when the PZT film 142 that is a ferroelectric film is formed at a temperature equal to or less than 450 degree centigrade, a film in which almost all grains have 001/100 orientation and that is high in the orientation properties can be obtained.

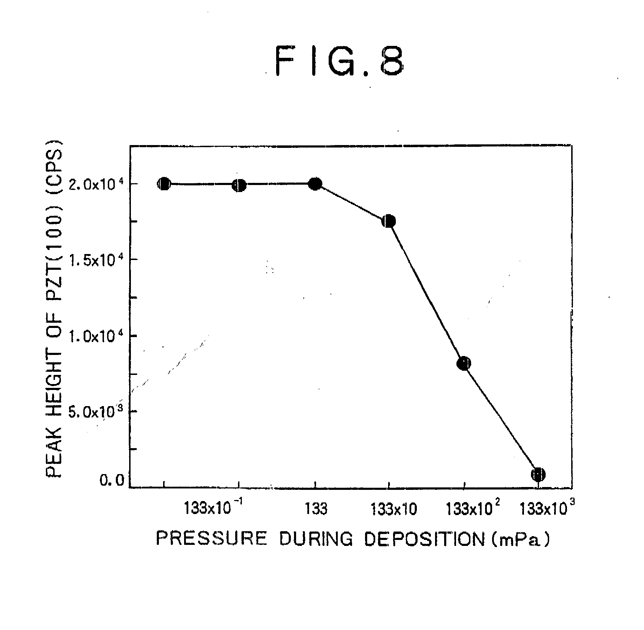

Furthermore, when the PZT film 142 is deposited according to the MOCVD method under the pressure of 1330 mPa or less, since micro-crystallites that are formed by reaction of raw material gas molecules and oxygen gas molecules before these gas molecules reach the substrate and that destroy a generated crystal structure can be suppressed from growing, a PZT film 142 higher in the crystal orientation can be formed at low temperatures. Fig. 8 is a diagram showing a change of peak height of 100 orientation observed in X-ray diffraction spectrum obtained by varying the pressure with the deposition temperature set at 400 degree centigrade. It is found that under the pressure higher than 1330 mPa, the peak height rapidly decreases.

Furthermore, when, as mentioned above, the process in which the initial nucleuses 142a are formed and thereafter a PZT film 142b to be integrated with the initial nucleuses 142a is formed is adopted, when the deposition conditions of the respective processes are differentiated, the PZT film 142 can be more preferably formed. That is, at the initial stage of the deposition of the ferroelectric film the raw material gases decompose on the lower electrode 141 and precursors of the constituent elements are absorbed. At this time, certain elements, in particular Pb and Bi tend to form. an alloy with a material of the lower electrode 141 and these elements become deficient in the neighborhood of an interface of the lower electrode 141, resulting in growing a thin film inferior in the ferroelectric properties. Accordingly, when, as mentioned above, initial nucleuses 142a are formed at feed amounts of raw material gases that supply the elements much at the initial stage of the deposition and at a low temperature of 330 degree centigrade, thereafter the substrate is heated up to 430 degree centigrade and the feed amounts of the raw material gases are altered to feed amounts of the raw material gases proper to form a PZT film, and thereby the PZT film 142b is formed, such problems can be overcome and the ferroelectric properties can be improved.

Here, the deposition temperature of the initial nucleuses 142a is restricted in the lower limit temperature to a temperature where the crystal nucleuses are generated. A temperature that allows crystallizing the initial nucleus is 300 degree centigrade or more, at 330 degree centigrade or more one that has the crystallinity .Chat can be more preferably used as a nucleus can be obtained. On the other hand, the upper limit of the deposition temperature is 450 degree centigrade, the growth temperature of the PZT film 142b. The reason for this is that since the orientation of the PZT film grown on the initial nucleuses is under an influence of the crystal orientation of the initial nucleuses, the initial nucleuses themselves have to be aligned in a single orientation. Thus, when the deposition temperature of the initial nucleuses 142a is set at low temperatures, a ferroelectric film. in which sizes of grains to be grown are smaller and that is less in the irregularity and flat can be obtained, and when a ferroelectric capacitor 140 having the MIM structure is formed in a post-process, nonuniformity in the characteristics caused by the fluctuation of the characteristics between grains is improved, resulting in being more advantageous in more miniaturizing a capacitor.

Still furthermore, in the deposition process of the initial nucleuses 142a, a process in which prior to the growth of the initial nucleuses 142a, Pb or Bi organometallic raw material gas may be brought into contact singly or together with an oxidizing gas with a surface of the lower electrode 141 may be provided. By thus implementing, before the initial nucleuses 142a grow, a surface of the lower electrode 141 can be flattened, and thereby a ferroelectric film excellent in the insulating properties can be formed.

After the PZT film 142 is thus formed, as shown in Fig. 5C, on the PZT film 142, IrO₂ that becomes an upper electrode 143 is deposited by means of the sputtering method to a film thickness of 100 nm. Thereafter, it is heat-treated in oxygen at 470 degree centigrade for 30 mm. Since the heat treatment temperature is as mentioned above higher than the deposition temperature, 450 degree centigrade, of the PZT film 142, a state equal to paraelectrics such as shown in Fig. 2B or nearly equal thereto results. In the phase transition, the diffusion of atoms and ions is not involved and except for the spontaneous polarization strain, there is no change in the fundamental crystal structure.

Thereafter, when cooled to normal temperature after the heat treatment, the temperature of the PZT film 142 is showered to a temperature equal to or lower than that at the deposition, and, as shown in Fig. 2C, the paraelectric phase undergoes the phase transition to the ferroelectric phase. The structures of the respective ferroelectric domains generated at this time and directions of the spontaneous polarizations thereof, irrespective of a state before the heat treatment, are determined by the thermal stress at the cooling and an internal electric field due to space charges. Since the P2T film is interposed between the lower electrode and the upper electrode, the internal electric field and the thermal stress are almost uniformly applied in the PZT film. Accordingly, reflecting the uniform strain and internal electric field, the spontaneous polarization orientations of the respective domains are aligned. When the spontaneous polarization orientations of the domains in the PZT film are aligned like this, the asymmetry of switching to the external electric field disappears and uniform polarization switching occurs. Furthermore, since the internal electric field that has partially blocked the domains is reduced owing to the heat treatment, the inactive domains become less than before the heat treatment is applied. An improvement in the symmetry of the inversion and a decrease in the inactive domains cause an increase in an amount of effective switchable charges.

Thereafter, as shown in Fig. 5D, according to photolithography a desired resist pattern is formed, with this as a mask dry etching is performed, thereby the upper electrode 143, the PZT film 142 and the lower electrode 141 are sequentially etched so as to leave a region above the contact plug 123 shown in Fig. 4 in an island shape of 2 µm square, and thereby a ferroelectric capacitor 140 having the MIM structure is formed.

Furthermore, as shown in Fig. 4, the ferroelectric capacitor 140 is covered by a fourth interlayer insulating film 114, in the fourth interlayer insulating film 114 a contact plug 124 that continues to the upper electrode 143 is formed, and on the fourth interlayer insulating film 114 a TiN/Al/TiN laminate film is formed by use of the sputtering method, and by forming into a necessary pattern a plate line 133 (PL) that is electrically connected through the contact plug 124 to the upper electrode 143 is formed. Further thereon, a passivation film 115 is formed. Thereby, a shadow RAM provided with the ferroelectric capacitors F0, F1 in the circuit shown in Fig. 3 is formed. In the ferroelectric capacitors F0, F1 in particular, since the breakdown voltage is high, an amount of effective switchable polarization can be increased.

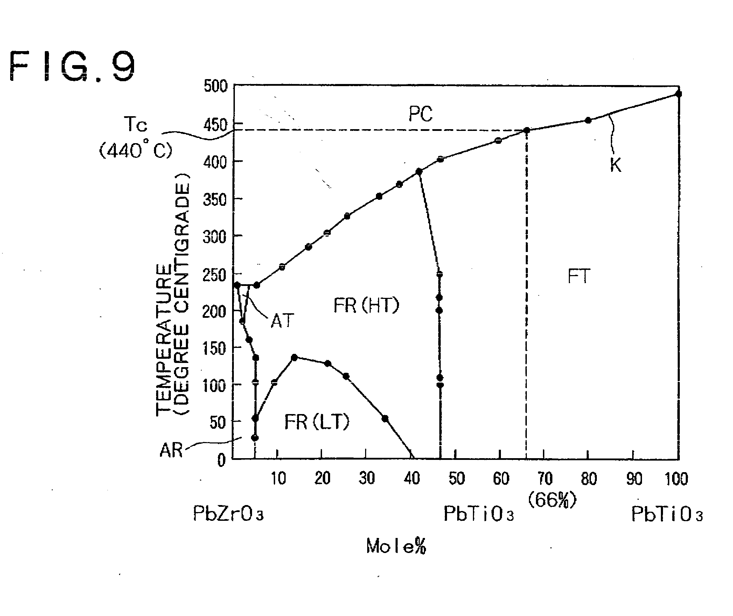

In a second fabricating method according to the invention of forming a PZT film 142 as the ferroelectric film, after a lower electrode 141 is formed similarly to the first fabricating method, a PZT film 142 having a composition the same as that of the first fabricating method is formed at 430 degree centigrade. The PZT film 142 formed here has a phase diagram as shown in Fig. 9 and can undergo transition to AT: tetragonal antiferroelectric phase, PC : cubic paraelectric phase, FT: tetragonal ferroelectric phase, F_{R} (HT): rhombohedral ferroelectric phase (high temperature phase), FR (LT): rhombohedral ferroelectric phase (low temperature phase), and AR: rhombohedral antiferroelectric phase. In particular, the PC is a structure that has no spontaneous strain due to the polarization (paraelectrics that lack the spontaneous polarization), the FT is a structure in which a direction that is distorted in a longitudinal or transversal direction corresponds to a direction of the polarization, and the FR is a structure in which a direction that is distorted in a diagonal direction corresponds to a direction of the polarization. In Fig. 9, a boundary line K between the PC and the FT and FR is a boundary between a ferroelectric phase and a paraelectric phase, that is, the Curie temperature Tc.

Based on the phase diagram of the PZT of Fig. 9, since the composition of the PZT film 142 formed in the process shown in the Fig. 5B is Pb(Zr₀.₃₃Ti_{0.67})O₃, as shown with an arrow line in the same drawing, the Curie temperature Tc that is expressed by the boundary K of crystal transition between the paraelectric properties and the ferroelectric properties of the PZT film 142 is substantially 440 degree centigrade. Accordingly, the PZT film 142 that is formed at 430 degree centigrade substantially similarly to the first fabricating method is formed at a temperature equal to or lower than the Curie temperature Tc. As a result, it is as mentioned above that the PZT film 142 being formed has a particular crystal orientation in which surface energy is small as shown in Fig. 2A, the ferroelectric domains thereof, though restricted in the spontaneous polarization directions by the crystal orientation, take various directions under the restriction, and lower residual. polarization value results.

Subsequently, as shown in Fig. 5C, on the PZT film 142, IrO₂ that becomes an upper electrode 143 is deposited to a thickness of 100 nm by means of the sputtering method. Thereafter, heat treatment is applied in oxygen at 470 degree centigrade for 30 min. Since the heat treatment temperature is as mentioned above higher than 440 degree centigrade that is the Curie temperature Tc as the upper limit of the deposition temperature of the PZT film 142, the spontaneous polarization disappears owing to the phase transition to the paraelectric phase as shown in Fig. 2B, however the phase transition does not involve the diffusion of atoms and ions, except for the spontaneous polarization strain, there is no change in the fundamental crystal structure.

Thereafter, when cooled to normal temperature after the heat treatment, the temperature of the PZT film 142 is lowered to a temperature equal to or lower than the Curie temperature Tc, and, as shown in Fig. 2C, the paraelectric phase undergoes the phase transition to the ferroelectric phase. The structures of the respective ferroelectric domains generated at this time and directions of the spontaneous polarizations thereof, irrespective of a state before the heat treatment is applied, are determined by the thermal stress at the cooling and an internal electric field clue to space charges. Since the PZT film is interposed between the lower electrode and the upper electrode that are made of metal, the internal electric field and the thermal stress are nearly uniform in the PZT film. Accordingly, reflecting the uniform strain and internal electric field, the directions of the spontaneous polarizations of the respective domains are aligned. When the spontaneous polarization directions of the domains in the PZT film are aligned like this, the asymmetry of switching to the external electric field disappears and uniform polarization switching occurs. Furthermore, since the internal electric field that has partially blocked the domains is reduced owing to the heat treatment, the inactive domains become less than before the heat treatment is applied. Thus, an improvement in the symmetry of inversion and a decrease in the inactive domains cause an increase in an amount of effective switchable polarization.

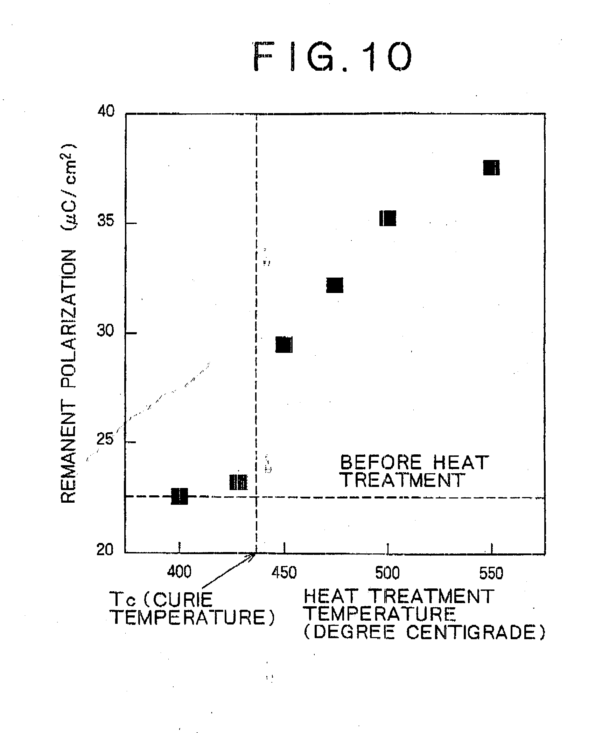

Fig. 10 is a diagram showing heat treatment temperature dependence of the remanent polarization in the PZT film 142 and it is found that while when the heat treatment temperature is equal to or lower than the Curie temperature Tc (440 degree centigrade), the remanent polarization is low, when the temperature is raised higher than the Curie temperature Tc, the remanent polarization increases.

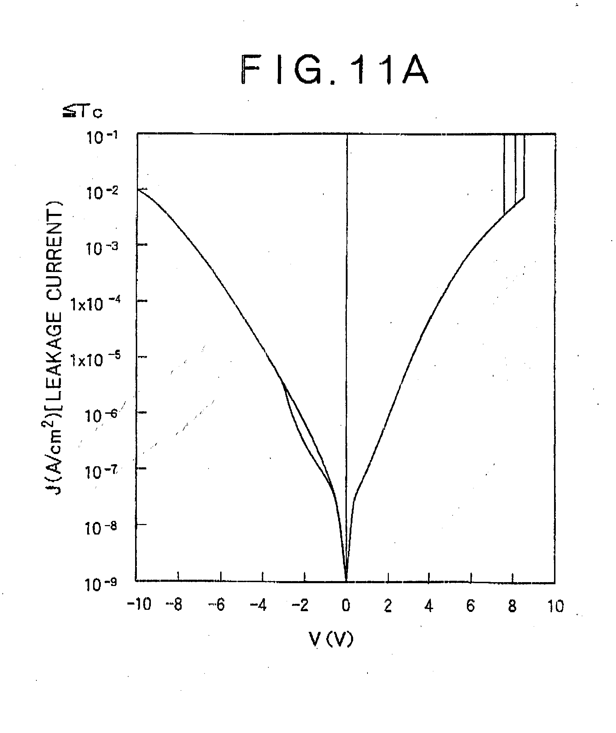

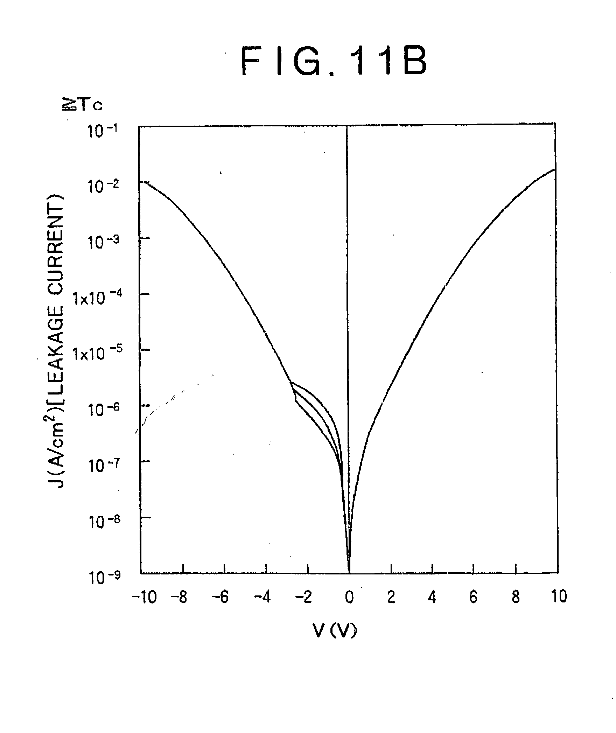

Furthermore, the reduction of the internal electric field in the PZT film 142 reduces the anti-voltage in directions other than the above. In addition, when the heat treatment is carried out in a state where the lower electrode 141 and the upper electrode 143 are in contact, structural defects at interfaces between the PZT film and the respective electrodes decrease, and an improvement in the breakdown voltage is also realized. Figs. 11A and 11B are diagrams showing leakage current characteristics of the PZT film 142 when the heat treatment temperature is equal to or lower than the Curie temperature Tc (Fig. 11A) and when it is higher than the Curie temperature Tc (Fig. 11B), and it is found that while the dielectric breakdown is caused at +8 V or more when the heat treatment temperature is equal to or lower than the Curie temperature Tc, when it is higher than the Curie temperature Tc, though there being only a little leakage current at +8 V or more, the dielectric: breakdown is not caused.

Thereafter, as shown in Fig. 5D, according to photolithography a desired resist pattern is formed, with this as a mask dry etching is performed, thereby the upper electrode 143, the PZT film 142 and the lower electrode 141 all shown in Fig. 4 are sequentially etched, and thereby a ferroelectric capacitor 140 having the MIM structure is formed. Furthermore, when processes similar to that of the first fabricating method are carried out, a shadow RAM provided with the ferroelectric capacitors F0, F1 in the circuit shown in Fig. 3 is formed. In the ferroelectric capacitors F0, F1 in particular, since the breakdown voltage is higher, an amount of effective switchable polarization inversion electric charges can be increased.

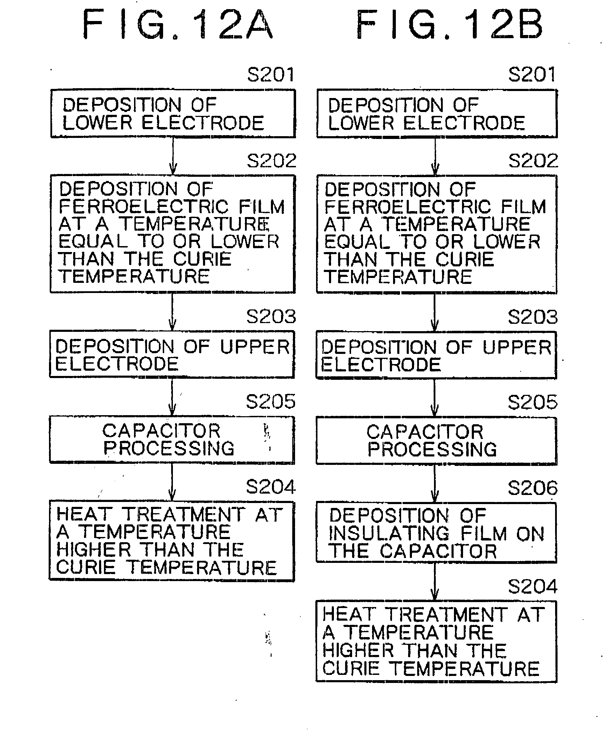

In the first and second fabricating methods, immediately after the upper electrode 143 of the ferroelectric capacitor 140 is formed, at 450 degree centigrade or more, or at a temperature higher than the Curie temperature, the heat treatment is applied. However, as the heat treatment, the heat treatment in the following mode also can be applied. A case in which after the deposition is carried out at a temperature equal to or lower than, for instance, the Curie temperature, the heat treatment is applied at a temperature higher than the Curie temperature will be taken as an example. In the first, as shown in the flowchart of Fig. 12A, after going through forming a lower electrode (step S201), forming a PZT film (step S202) and forming an upper electrode (step S203), forming an upper electrode 143, a PZT film 142 and a lower electrode 141 into a necessary pattern, here a rectangular island-like pattern (step S205) is applied, and after forming a ferroelectric capacitor 140 having the pattern according to the process, heat treatment (step S204) may be applied. Furthermore, in the second, as shown in the flowchart of Fig. 12.B, after forming an upper electrode (step S203), after etching an upper electrode 143, a PZT film 142 and a lower electrode 141 into a necessary pattern and thereby forming a ferroelectric capacitor into a necessary pattern (step S205), further after forming a fourth interlayer insulating film 114 that covers the ferroelectric capacitor (step S206), heat treatment (step S204) may be applied. In the case of the first fabricating method, the steps S202 and S204, respectively, can be read as "deposition of the ferroelectric film at 450 degree centigrade or less" and "heat treatment at a temperature higher that that of the deposition".

Furthermore, though omitted from showing in the drawing, after forming a further upper layer wiring, heat treatment may be applied. Thus, by applying heat treatment during an arbitrary step after the forming the ferroelectric capacitor, heat treatment according to the invention can be applied simultaneously with various kinds of heat treatments required during the processes after the ferroelectric capacitor is formed, accordingly, it is advantageous in reducing the steps of the heat-treatment.

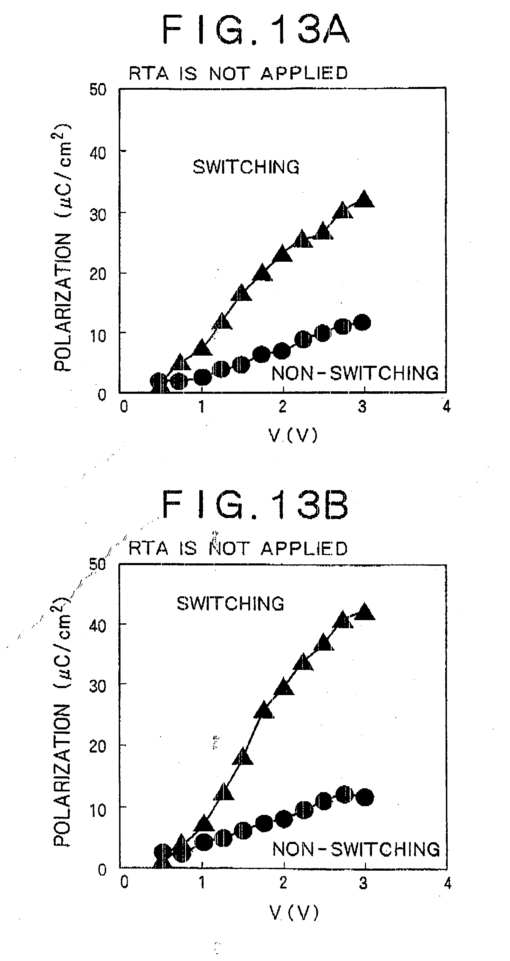

Still furthermore, the heat treatment after the upper electrode is formed may be implemented according to an RTA (rapid thermal annealing) method. Though in the above embodiment the heat treatment is applied at 470 degree centigrade for 30 min, in place of this, for instance, the heat treatment may be applied by use of the RTA method at 550 degree centigrade for 30 seconds. When the heat treatment according to the RTA method is thus applied, damage due to heat on the MOS transistors and other wiring layers may be alleviated on one hand, on the other hand the pulse hysteresis in the ferroelectric capacitor can be improved. Figs. 13A and 13B are diagrams showing one example thereof, Fig. 13A showing values of switching and non-switching polarizations in the case where the RTA method is not applied, Fig.13B showing that in the case where the heat treatment is applied according to the RTA method. It is found from this that when the RTA method is applied, a ferroelectric capacitor in which difference of values of Switching and non-switching polarizations is large, an amount of switchable polarization is increased, and the symmetry of the switching characteristics is excellent can be obtained.

When the ferroelectric film according to the invention is deposited, deposition methods such as the CVD method and the sputtering method other than the MOCVD method according to the embodiment can be adopted. However, when the MOCVD method is used, there are advantages over other deposition methods in that the orientation at 450 degree centigrade or lower or at the Curie temperature or lower can be made more excellent.

In the invention, the ferroelectric film, without restricting to the PZT film, may be ones that are mainly made of ferroelectrics having a chemical formula ABO₃. In the formula, A denotes at least one kind or more of Ba, Sr, Pb, Ca, La, Li and K, and B denotes at least one kind or more of Zr, Ti, Ta, Nb, Mg, Mn, Fe, Zn and W. Such ferroelectrics are known as ferroelectric films having the perovskite crystal structure.

Alternatively, the ferroelectric film may be mainly constituted of ferroelectrics expressed with a chemical formula Bi₂O₂(Aₘ₋₁BₘO₃ₘ₊₁). In the formula, m is 1, 2, 3, 4 or 5, A is at least one kind or more of Ba, Sr, Pb, Ca, K and Bi, and B is at least one kind or more of Nb, Ta, Ti and W. For instance, bismuth titanate can be applied.

Furthermore, as the lower electrode and the upper electrode that form a capacitor together with the ferroelectric film, other than the Pt, one of materials that are mainly constituted of Ru, Ir or oxides thereof can be applied. When one of these materials is used, it is advantageous in that the ferroelectric film can be grown at lower temperatures. In particular when a capacitor that is constituted with Ru, Ir or oxides thereof as the upper and lower electrodes is used as a memory, it is known that read/write endurance (life-time) can be extended. Furthermore, since Ru and oxide thereof can be subjected to chemical dry etching, these can be very advantageously used in highly integrating a semiconductor device.

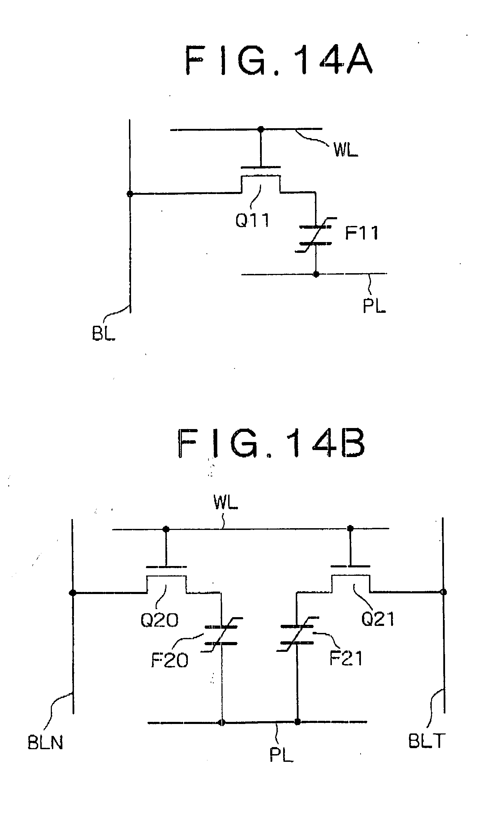

Furthermore, it goes without saying that the invention, without restricting to the method of fabricating the ferroelectric capacitor that is used in the shadow RAM according to the embodiment, can be similarly applied to any capacitors that have the MIM structure where the ferroelectric film is used as dielectrics.The invention can be applied to the fabrication of a so-called 1T1C type FeRAM (nonvolatile ferroelectric memory) in which, as a circuit diagram is shown in, for instance, Fig. 14A, one transistor Q11 and one ferroelectric capacitor F11, respectively, are connected to a word line WL, a bit line BL and a plate line PL. Similarly, as a circuit diagram is shown in, for instance, Fig. 14B, the invention can be applied to the fabrication of a so-called 2T2C type FeRAM in which two transistors Q20 and Q21 and two ferroelectric capacitors F20 and F21, respectively, are connected to a word line WL, bit lines BLN and BLT and a plate line PL.

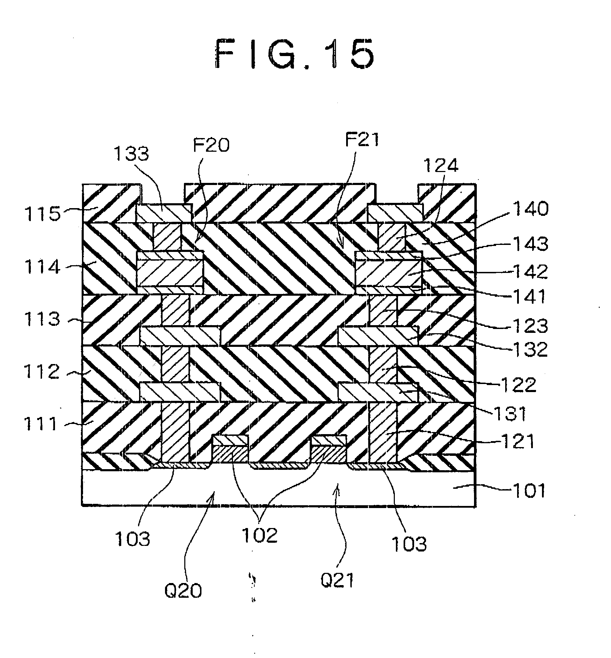

A configuration of, for instance, a 2T2C type DRAM is shown in a schematic sectional view of Fig. 15. In the drawing, portions equivalent with Fig. 4 are given the same reference numerals. On a surface of a silicon substrate 101, gate electrodes (word lines) 102 are formed, furthermore on a main surface of the silicon substrate 101 source and drain regions 103 are formed, and thereby two MOS transistors Q20, Q21 are formed. A first interlayer insulating film 111 made of a silicon oxide film is formed so as to cover the MOS transistors Q20, Q21, and in the first interlayer insulating film 111 contact holes are opened so as to electrically connect with source regions 103 of the MOS transistors Q20, Q21, and in the contact holes a conductive material such as tungsten is buried and thereby contact plugs 121 are formed. Then, a multi-layered wiring structure is formed by sequentially laminating, on the first interlayer insulating film 111, a first wiring layer 131, a second interlayer insulating film 112, a second wiring layer 132, and a third interlayer insulating film 113, from the first wiring layer 131 bit lines BL, BLT being formed, from the second wiring layer 132 a power supply VCC line and a GND line being formed. The first wiring layer 131 is electrically connected through the contact plug 121 to the MOS transistors The second wiring layer 132 of the power supply VCC line and the GND line is electrically connected through the contact plugs 122, 121 respectively formed in the second interlayer insulating film 112 and the first interlayer insulating film 111 to the MOS transistors. Furthermore, on the uppermost third interlayer insulating film 113, ferroelectric capacitors 140 (F20, F21) having the MIM structure are formed, lower electrodes 141 each are connected through the contact plugs 123 and 122 respectively formed in the third interlayer insulating film 113 and in the second interlayer insulating film 112 to the source region 103. Furthermore, the ferroelectric capacitor 140 is covered with a fourth interlayer insulating film 114, and upper electrodes 143 each of the ferroelectric capacitors 140 are connected through a contact plug 124 disposed in the fourth interlayer insulating film 114 to a plate line 133 formed on the fourth interlayer insulating film 114.

As described above, in the invention, after a ferroelectric film is formed on a lower electrode at a, temperature of 450 degree centigrade or less, or at a temperature of Curie temperature or less, thereon an upper electrode is formed, thereafter heat treatment is applied at a temperature higher than a deposition temperature or a temperature higher than the Curie temperature, and thereby a ferroelectric capacitor having the MIM structure is formed. Accordingly, the deposited ferroelectric film has a particular crystal orientation, when the ferroelectric film is heated to a temperature higher than the deposition temperature or the Curie temperature to cause a transition once to a paraelectric phase or a state close thereto, a finally obtained ferroelectric film, without altering a fundamental crystal structure formed at the deposition, can undergo a phase transition to a ferroelectric phase. Accordingly, reflecting uniform strain and an internal electric field, a ferroelectric film aligned in the spontaneous polarization direction can be obtained. Thereby, a ferroelectric capacitor in which asymmetry of switching to an external electric field disappears and polarization switching occurs uniformly, an internal electric field is reduced and inactive domains are reduced in comparison with before the heat treatment, an amount of switchable polarization is increased, and the breakdown voltage is made higher can be obtained.

## Claims

1. A method of fabricating a semiconductor device, comprising the steps of:
forming a lower electrode;
forming, on the lower electrode, a ferroelectric film at a temperature equal to the Curie temperature of the ferroelectric film or less ;
forming an upper electrode on the ferroelectric film; and
applying heat treatment at a temperature higher than the Curie temperatures
thereby forming a capacitor formed of the lower electrode, the ferroelectric film and the upper electrode.

2. A method of fabricating a semiconductor device, comprising the steps of :
forming a lower electrode ;
forming, on the lower electrode, a ferroelectric film crystallized in a perovskite structure at a temperature of 450 degree centigrade or less ;
forming an upper electrode on the ferroelectric film; and
applying heat treatment at a temperature higher than a deposition temperature of the ferroelectric film ;
thereby forming capacitor formed of the lower electrode, the ferroelectric film and the-upper electrode.

3. The method of fabricating a semiconductor device as set forth in any one of claims 1 and 2:
wherein the forming the ferroelectric film is a vapor growth method (MOCVD method) with an organometallic material gas.

4. The method of fabricating a semiconductor device as set forth in any one of claims 1 and 2:
wherein the forming the ferroelectric film is a vapor growth method (MOCVD method) with an organometallic material gas; and a pressure during growth is 1330 mPa or less.

5. The method of fabricating a semiconductor device as set forth in any one of claims 1 through 4:
wherein the forming the ferroelectric film includes forming an initial nucleus on a surface of the lower electrode, and said ferroelectric film is formed on the initial nucleus under deposition conditions different from that in the forming the initial nucleus.

6. The method of fabricating a semiconductor device as set forth in any ones of claims 1 through 4:
wherein the forming the ferroelectric film includes supplying, on the lower electrode, a Pb or Bi organometallic raw material gas alone or together with oxidizing gas, and said ferroelectric film is formed thereafter.

7. The method of fabricating a semiconductor device as set forth in claim 5 :
wherein the forming the ferroelectric film includes supplying, on the lower electrode, a Pb or Bi organometallic raw material gas alone or together with oxidizing gas, and said initial nucleus is formed thereafter.

8. The method of fabricating a semiconductor device as set forth in Claim 5:
wherein the initial nucleus is formed at a temperature in the range of 300 to 450 degree centigrade, and the ferroelectric film is formed at a temperature equal to or higher than that.

9. The method of fabricating a semiconductor device as set forth in any one of Claims 1 through 8:
wherein between the forming the upper electrode layer and the heat treatment, forming the upper electrode into a necessary pattern is included.

10. The method of fabricating a semiconductor device as set forth in any one of Claims 1 through 8:
wherein between the forming the upper electrode layer and the heat treatment, forming the ferroelectric film and the lower electrode into a necessary pattern is included.

11. The method of fabricating a semiconductor device as set forth in Claim 9:
wherein between the forming the upper electrode layer into a necessary pattern and the heat treatment, forming a inter-layer-dielectric film that covers at least the upper electrode is included.

12. The method of fabricating a semiconductor device as set forth in any one of Claims 1 through 11 :
wherein the heat treating is applied according to an RTA method (rapid thermal annealing method).

13. The method of fabricating a semiconductor device as set forth in any one of Claims 1 through 12:
wherein the ferroelectric film is substantially formed of ferroelectrics expressed by a chemical formula ABO₃ (A denotes at least one kind or more of elements selected from a group of Ba, Sr, Pb, Ca, La, Li and K, and B denotes at least one kind or more of elements selected from a group of Zr, Ti, Ta, Nb1 Mg, Mn, Fe, Zn, and W).

14. The method of fabricating a semiconductor device as set forth in any one of Claims 1 through 12:
wherein the ferroelectric film is substantially formed of ferroelectrics expressed by a chemical formula Bi₂O₂(Aₘ₋₁BₘO₃ₘ₊₁) (m is 1, 2, 3, 4 or 5, A denotes at least one kind or more of elements selected from a group of Ba, Sr, Pb, Ca, K and Bi, and B denotes at least one kind or more Of elements selected from a group of Nb, Ta, Ti and W).

15. The method of fabricating a semiconductor device as set forth in any one of Claims 1 through 14:
wherein the initial nucleus is lead titanate or bismuth titanate.

16. The method of fabricating a semiconductors device as set forth in any one of Claims 1 through 15:
wherein the lower electrode and the upper electrode are substantially made of Ru, Ir or oxides thereof, or Pt.
